Europäisches Patentamt

European Patent Office

Office européen des brevets

(19)

(11) Numéro de publication : **0 157 677 B2**

# (12) NOUVEAU FASCICULE DE BREVET EUROPEEN

(45) Date de publication du nouveau fascicule du brevet : **23.12.92 Bulletin 92/52**

(51) Int. Cl.⁵ : **H01L 21/90, H01L 23/52**

(21) Numéro de dépôt : **85400469.4**

(22) Date de dépôt : **12.03.85**

(54) **Procédé pour interconnecter les zones actives et/ou les grilles d'un circuit intégré CMOS.**

(30) Priorité : **19.03.84 FR 8404204**

(43) Date de publication de la demande :
**09.10.85 Bulletin 85/41**

(45) Mention de la délivrance du brevet :
**02.11.88 Bulletin 88/44**

(45) Mention de la décision concernant
l'opposition :
**23.12.92 Bulletin 92/52**

(84) Etats contractants désignés :
**CH DE GB IT LI NL**

(56) Documents cités :
**EP-A- 0 072 522**
**EP-A- 0 091 870**
**EP-A- 0 091 870**
**WO-A-84/01052**
**FR-B- 2 567 301**
**US-A- 4 234 362**

(56) Documents cités :
**US-A- 4 267 012**
**SOLID STATE TECHNOLOGY, volume 25,
décembre 1982, pages 85-90, Port Washingtn,
US; N.E. MILLER: "CVD tungsten interconnectand contact barrier technolgy for VLSI"
I. RUGE; Halbleitertechnologie, Springer
Verlag, 1975, p.330, 331**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**

(72) Inventeur : **Hartmann, Joel
13, rue de la Balmette
F-38640 Claix (FR)**
Inventeur : **Jeuch, Pierre
13, rue du Parc
F-38170 Seyssins (FR)**

(74) Mandataire : **Mongrédien, André et al
c/o BREVATOME 25, rue de Ponthieu
F-75008 Paris (FR)**

EP 0 157 677 B2

## Description

La présente invention a pour objet un procédé pour interconnecter les zones actives et/ou les grilles d'un circuit intégré CMOS. Ce procédé permet en particulier de réaliser des connexions à courtes distances entre tes sources et les drains des transistors MOS (métal-oxyde-semiconducteur) à canal N ou P entrant dans ta constitution du circuit intégré CMOS (MOS complémentaire) et aussi de connecter ces sources et/ou ces drains avec tes grilles de ces mêmes transistors.

Les circuits intégrés CMOS, dont le plus simple est un inverseur, constitué uniquement d'un transistor à canal N et d'un transistor à canal P dont l'un est bloqué quand l'autre conduit et vice versa, présentent l'avantage de consommer très peu d'énergie électrique. En revanche, ils présentent une faible densité d'intégration.

Cette faible densité d'intégration est liée en particulier à la nécessité de connecter fréquemment des régions de type N + (source ou drain des transistors à canal N) et des régions de type P+ (source ou drain des transistors à canal P), cette nécessité s'expliquant par le fait que chaque porte élémentaire du circuit intégré comprend à la fois des transistors à canal N et des transistors à canal P.

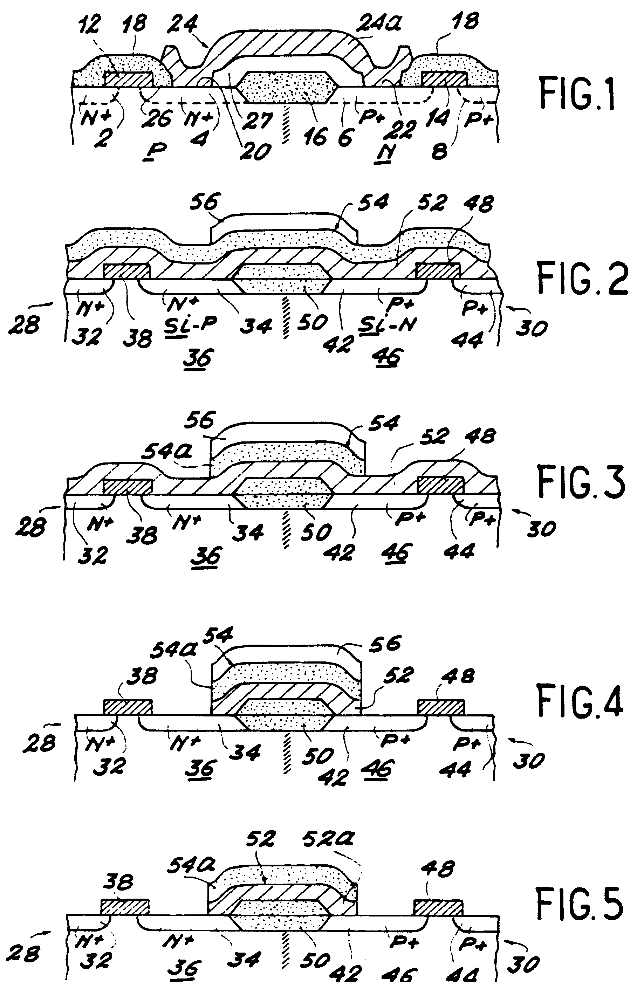

Ces connexions, comme représenté sur la figure 1 illustrant en coupe longitudinale un inverseur CMOS, sont actuellement obtenues, après avoir réalisé les éléments constitutifs du circuit, c'est-à-dire les zones actives telles que les sources 2 et 8 et les drains 4 et 6 des transistors du circuit, les grilles 12 et 14 de ces transistors et l'oxyde de champ 16, en déposant tout d'abord sur l'ensemble du circuit intégré une couche d'isolant 18, généralement en oxyde de silicium, puis en gravant cette couche d'isolant afin de réaliser les trous de contact électrique, tels que 20 et 22, des zones actives ainsi que ceux des grilles. Ensuite, on dépose sur la couche d'isolant gravée 18 une couche conductrice 24, généralement en aluminium, puis on grave celle-ci afin de réaliser les connexions voulues, tel les que la connexion 24a entre le drain 4 du transistor à canal N et le drain 6 du transistor à canal P de l'inverseur.

Dans un tel procédé, outre la surface occupée par les connexions elles-mêmes, ce sont essentiellement les trous de contact électrique (20, 22) réalisés dans la couche d'isolant, et les gardes tel les que 26 et 27 nécessaires pour le positionnement de ces trous qui réduisent la densité d'intégration des circuits intégrés CMOS.

Afin d'augmenter la densité d'intégration de ces ci rcuits CMOS, notamment en diminuant la surface occupée par les connexions, on réalise parfois des circuits à deux niveaux d'interconnexion, généralement en aluminium, mais ceci complique le procédé de fabrication des circuits de façon significative, et ne permet pas, de toute façon, de supprimer les encombrements des trous de contact électrique, réalisés dans la couche d'isolant.

La présente invention a justement pour objet un procédé pour interconnecter les zones actives et éventuellement les grilles des circuits intégrés CMOS permettant de remédier à ces inconvénients et permettant notamment d'augmenter de façon notable la densité d'intégration de ces circuits.

Ce procédé permet, après la réalisation des éléments constitutifs du circuit intégré, tel les que les zones actives, les grilles et l'oxyde de champ, de réaliser les différentes connexions voulues, sans avoir au préalable déposé sur l'ensemble du circuit intégré une couche isolante et réaliser, dans cette couche, des trous de contact électrique nécessaires pour réaliser les connexions.

Il peut être utilisé avantageusement pour effectuer des liaisons à courtes distances, c'est-à-dire des liaisons entre les sources et drains et/ou les grilles des transistors du circuit intégré.

De façon plus précise, l'invention a pour objet un procédé pour interconnecter les zones actives et éventuellement les grilles d'un circuit intégré CMOS. Ce procédé consiste en particulier, après avoir réalisé les éléments constitutifs du circuit intégré, à l'exception des connexions, à déposer directement sur l'ensemble du circuit une couche d'un matériau conducteur, dit premier matériau, puis à graver cette couche de matériau conducteur afin de réaliser les connexions voulues.

Par éléments constitutifs d'un circuit intégré, il faut comprendre tout ce qui constitue le circuit, c'est-à-dire l'oxyde de champ, les sources, drains et grilles des transistors, les circuits à transfert de charge (CCD) etc..., avant que l'on ait réalisé les différentes connexions du circuit ; la touche d'isolant, dans laquelle on réalise les trous de contact électrique, utilisée dans l'art antérieur pour permettre la réalisation des connexions du circuit ne fait bien entendu pas partie des éléments constitutifs du circuit intégré.

Le fait de supprimer, dans le procédé de l'invention, le dépôt de la couche isolante et la réalisation des trous de contact électrique dans cette couche, pour ràaliser les différentes connexions du circuit, permet d'augmenter de façon considérable la densité d'intégration des circuits CMOS.

Selon la caractéristique principale du procédé de l'invention, on effectue les étapes successives suivantes :

- dépôt directement sur l'ensemble du circuit intégré de la couche du premier matériau conducteur,
- dépôt sur la couche du premier matériau conducteur d'une couche d'un matériau non réfléchissant, dit deuxième matériau, ce deuxième matériau étant différent du premier matériau conducteur,
- réalisation d'un masque de résine sur la couche du deuxième matériau représentant l'image du premier niveau d'interconnexions à réaliser,

- élimination de la partie de la couche du deuxième matériau dépourvue de masque,

- élimination de la partie de la couche du premier matériau conducteur dépourvue du restant de la couche du deuxième matériau afin de réaliser le premier niveau d'interconnexions, et

- élimination du masque.

Selon un mode particulier de mise en oeuvre du procédé de l'invention, la couche du premier matériau conducteur est gravée au moyen d'un plasma.

Afin de réaliser un auto-alignement des connexions sur les zones actives (source et drain) des circuits intégrés, le procédé objet de l'invention peut avantageusement comprendre les étapes successives suivantes :

- isolation latérale des grilles du circuit intégré,

- dépôt directement sur l'ensemble du circuit intégré de la couche du premier matériau conducteur,

- dépôt sur la couche du premier matériau conducteur de la couche du deuxième matériau non réfléchissant,

- dépôt sur la couche du deuxième matériau d'une première couche de résine servant à effacer le relief de la couche du deuxième matériau,

- réalisation d'une gravure de la première couche de résine afin de ne laisser de la résine qu'aux emplacements des zones actives à interconnecter,

- réalisation dans une deuxième couche de résine d'un masque représentant l'image du premier niveau d'interconnexions à réaliser,

- élimination de la partie de la couche, du deuxième matériau, dépourvue de résine,

- élimination de la partie de la couche du premier matériau conducteur non recouverte par le restant de la couche du deuxième matériau

- élimination de la résine.

De façon avantageuse, la couche du premier matériau conducteur est réalisée en un alliage de titane et de tungstène et la couche du deuxième matériau en silicium ou en oxyde de silicium.

D'autres caractéristiques et avantages de l'invention ressortiront mieux de la description qui va suivre, donnée à titre illustratif et non limitatif , en référence aux figures annexées, dans lesquelles :

- la figure 1, déjà décrite, représentant en coupe longitudinale un inverseur CMOS, illustre le procédé d'interconnexion d'un tel circuit selon l'art antérieur,

- les figures 2 à 5, illustrent, en coupe longitudinale, les différentes étapes du procédé de l'invention, conformément à un premier mode de mise en oeuvre, et

- les figures 6 à 9 illustrent, en coupe longitudinale, les différentes étapes du procédé de l'invention, conformément à un deuxième mode de mise en oeuvre.

Sur les figures 2 à 5, on a représenté un inverseur CMOS, constitué d'un transistor MOS 28 à canal N et d'un transistor MOS 30 à canal P que l'on désire interconnecter.

Le transistor 28 à canal N comporte une source 32 et un drain 34, réalisés dans un substrat semiconducteur 36, par exempte en silicium de type P, ainsi qu'une grille 38, réalisée par exempte en silicium polycristallin dopé. De même, le transistor 30 à canal P comporte une source 44 et un drain 42, réalisés dans un substrat semiconducteur 46, notamment en silicium de type N, ainsi qu'une grille 48 par exemple en silicium polycristallin dopé ou en siliciure.

Ces transistors 28 et 30 sont séparés l'un de l'autre par un oxyde de champ 50 réalisé par exemple selon la technologie LOCOS (oxydation localisée). Cet oxyde de champ 50 est partiellement enterré dans le substrat semiconducteur.

Les sources, les drains et les grilles de ces deux transistors 28 et 30 ainsi que l'oxyde de champ 50 représentent ce qu'on appel le les éléments constitutifs du circuit intégré, ici un inverseur CMOS.

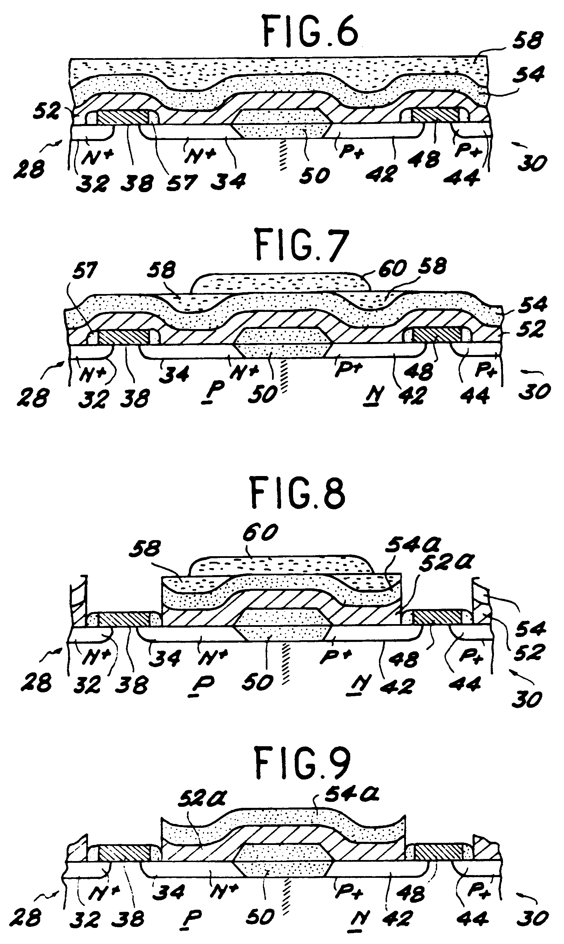

Conformément à l'invention, l'interconnexion du drain 34 du transistor 28 à canal N et du drain 42 du transistor 30 à canal P est réalisée, en déposant directement sur l'ensemble du circuit intégré une couche 52 de matériau conducteur, dit premier matériau, puis en gravant cette couche 52 de premier matériau conducteur afin de réaliser la connexion désirée (figure 5), notamment la connexion du drain 34 et du drain 42 du circuit intégré. Cette couche 52, de préférence en un alliage de titane et de tungstène comprenant par exemple 90 % en poids de tungstène et 10 % en poids de titane, peut être déposée par la technique de dépôt par pulvérisation magnétron. Elle présente par exemple une épaisseur de 0,1 μm.

La gravure de cette couche conductrice 52 peut être réalisée, comme représenté sur les figures 2 à 5, c'est-à-dire en déposant tout d'abord sur cette couche 52 une couche 54 d'un deuxième matériau, ce deuxième matériau étant différent du premier matériau constituant la couche 52. Cette couche 54, déposée par exemple par la technique de pulvérisation magnétron peut être réalisée en silicium ou en oxyde de silicium. Elle peut présenter une épaisseur d'environ 500 Å (5.10⁻² μm).

On réalise ensuite sur cette couche 54 un masque 56, par exemple en résine par les procédés classiques de la photolithographie, représentant l'image de la connexion 52a (figure 3) à réaliser, c'est-à-dire servant à définir les dimensions de cette connexion.

Après la réalisation du masque, on élimine la partie de la couche 54 de deuxième matériau dépourvue de masque. La structure obtenue est représentée sur la figure 3. Lorsque la couche 54 est réalisée en oxyde de silicium, la gravure de celle-ci peut par exemple être réalisée chimiquement avec de l'acide fluorhydrique (HF) comme agent d'attaque et lorsque la couche est réalisée en silicium, cette gravure peut être réalisée en utilisant un plasma contenant de l'hexafluorure de soufre ($SF_6$).

Les étapes suivantes du procédé de l'invention consistent à éliminer la partie de la couche 52 du premier matériau conducteur non recouverte du restant 54a de la couche 54, comme représenté sur la figure 4. La gravure de la couche conductrice 52, le restant 54a de la couche 55 servant de masque à cette gravure, peut être réalisée par attaque chimique, par exemple à l'aide d'une solution contenant de l'acide sulfurique ($H_2SO_4$) et de l'eau oxygénée ($H_2O_2$) lorsque cette couche 52 est réalisée en Ti-W.

Ce mélange d'acide sulfurique et d'eau oxygénée permet d'éliminer également le masque de résine 56. La structure finale est représentée sur la figure 5.

La couche 52 de matériau conducteur ainsi gravée permet de connecter entre eux le drain 34 du transistor 28 à canal N et le drain 42 du transistor 30 à canal P.

Outre son rôle de masque pour la gravure de la couche 52, l'emploi d'une couche 54 de deuxième matériau en silicium ou en oxyde de silicium permet d'éviter, lors de l'insolation de la résine photosensible pour la réalisation du masque, le phénomène d'interférence dans ladite résine, ce phénomène étant dû au grand pouvoir réfléchissant des couches conductrices généralement utilisées (ici Ti-W). Ceci permet d'obtenir, dans la couche de résine, une image plus précise de la connexion à réaliser.

Sur les figures 6 à 9, on a représenté un autre mode de mise en oeuvre du procédé selon l'invention. Ce mode de mise en oeuvre permet d'obtenir un auto-alignement de la ligne d'interconnexion à réaliser, par exemple la ligne 52a, sur les zones actives à connecter, par exemple le drain 34 et le drain 42 respectivement des transistors 28 à canal N et 30 à canal P.

Comme précédemment, après avoir réalisé les éléments constitutifs du circuit intégré, c'est-à-dire les sources, les drains et les grilles des transistors 28 et 30 et l'oxyde de champ 50, on réalise, comme représente sur la figure 6, une isolation latérale 57 des grilles 38 et 48 du circuit intégré ayant la forme de bandes isolantes d'environ 2500 Å (0,25 µm) de large. Cette isolation latérale peut être réalisée en oxyde de silicium ou en nitrure de silicium. Elle peut être réalisée de façon connue, par exemple à l'aide du procédé décrit dans le brevet américain n° 4 234 362 déposé le 18 novembre 1980 de J.RISEMAN ou bien à l'aide du procédé décrit dans le brevet français n° 2 525 029 déposé le 8 avril 1982 au nom du demandeur.

Il est à noter que l'oxyde de champ 50 a été représenté, comme précédemment, partiellement enterré dans le substrat semiconducteur (LOCOS). Cependant, dans ce mode de mise en oeuvre du procédé de l'invention, l'oxyde de champ 50 pourrait avantageusement être réalisé entièrement en relief.

Après la réalisation de cette isolation latérale 57 des grilles du circuit intégré, on dépose sur l'ensemble de ce circuit, par exemple par la technique de dépôt par pulvérisation magnétron, la couche 52 de matériau conducteur, réalisée de préférence en Ti-W et ayant une épaisseur de 0,1 micromètre environ. Cette couche d'épaisseur constante, présente un profil dépendant de la forme des couches sous-jacentes et notamment des creux au niveau des zones actives (drains 34 et 42).

Ensuite, on dépose sur cette couche 52 de matériau conducteur une couche 54 d'un deuxième matériau, ce matériau étant différent du matériau constituant la couche conductrice 52. Cette couche 54, réalisée de préférence en silicium ou en oxyde de silicium, présente aussi un profil dépendant de la forme des couches sous-jacentes, ici la couche conductrice 52, et en particulier comporte des creux aux endroits des zones actives (drains 34 et 42).

Cette couche 54 est ensuite recouverte d'une première couche de résine photosensible 58, telle que celle utilisée usuellement en photolithographie. Selon la viscosité de la résine utilisée, on procédera avantageusement à un traitement thermique de la couche de résine 58 afin d'obtenir une surface aussi plane que possible, par exemple un chauffage entre 200°C et 250°C.

L'étape suivante du procédé consiste à réaliser, comme représenté sur la figure 7, une gravure de la couche de résine 58 afin de ne laisser de la résine qu'aux emplacements des zones actives à interconnecter, par exemple les drains 34 et 42, c'est-à-dire aux endroits en creux de la couche 54. Le fait de ne garder de la résine 58 qu'aux emplacements des zones actives se fait automatiquement, compte tenu du profil de la couche 54. Cette gravure peut être réalisée par exemple à l'aide d'un procédé de gravure sèche utilisant un plasma d'oxygène.

Après cette gravure de la couche de résine 58, on réalise dans une deuxième couche de résine 60, un masque représentant l'image de la connexion 52a à réaliser selon les procédés classiques de la photolithographie.

L'étape suivante du procédé consiste, comme représenté sur la figure 8, à éliminer la partie de la couche 54 de deuxième matériau dépourvue de résine, c'est-à-dire non recouverte par le masque 60 et le restant de la couche de résine 58 remplissant les creux de la couche 54,. Cette élimination peut se faire en gravant la couche 54 par attaque chimique, notamment avec de l'acide fluorhydrique comme agent d'attaque lorsque celle-ci est réalisée en $SiO_2$.

Après cela, on élimine la partie de la couche 52 de matériau conducteur non masquée, c'est-à-dire non recouverte du restant 54a de la couche 54 du deuxième matériau. Dans le cas d'une couche conductrice 52 en un alliage de titane et de tungstène, cette gravure peut être réalisée en utilisant un plasma

contenant du $SF_6$.

Enfin, comme représenté sur la figure 9, on élimine la résine, c'est-à-dire le masque 60 et le reste de la couche de résine 58.

Le fait de graver la couche 51 de matériau conducteur pour obtenir la connexion 51a des zones actives 34 et 42, en utilisant le masque de résine 60 et la couche de résine 58 gravée comme précédemment, permet d'obtenir une connexion 51a entre les zones actives 34 et 42 du circuit intégré dont les extrémités arrivent au contact des isolations latérales 57 ou bandes isolantes des grilles 38 et 48 du circuit intégré, c'est-à-dire un auto-alignement de la connexion 52a sur lesdites zones actives. Cet auto-alignement présente l'avantage de supprimer les gardes normalement nécessaires à l'alignement du masque de la résine 60 sur les zones actives 34 et 42.

L'emploi d'une couche 54 de deuxième matériau en silicium ou en oxyde de silicium permet d'éviter l'exposition de la couche 52 en TiW à une atmosphère oxydante lors des étapes ultérieures.

Comme on l'a dit précédemment, la couche 54 de deuxième matériau, sert en particulier à obtenir, dans la résine constituant le masque 60, une meilleure image de la connexion 52a à réaliser.

Dans le mode de mise en oeuvre du procédé de l'invention, utilisant des isolations latérales 57 des grilles du circuit intégré (figures 6 à 9), il est possible de réaliser une étape supplémentaire, juste après la réalisation de ces isolations, consistant à implanter des ions dans les zones actives à connecter, et notamment dans les drains 34 et 42 du circuit intégré. Cette implantation ionique permet notamment d'éviter les risques de court-circuit entre les sources ou les drains du circuit intégré et le substrat dudit circuit et notamment au bord de l'oxyde de champ, ce court-circuit pouvant provenir d'une légère attaque de l'oxyde de champ lors des différentes étapes du procédé de l'invention et notamment lors de la réalisation des isolations latérales 57 des grilles du circuit intégré.

Cette implantation ionique permet aussi d'obtenir au niveau des grilles, notamment 38 et 48 du circuit intégré, une double jonction de sources et drains, ce qui permet de diminuer le champ électrique entre les drains et les grilles adjacents.

Cette implantation ionique peut être réalisée en masquant à chaque fois les régions complémentaires, c'est-à-dire les régions de type N+ puis les régions de type P+ à l'aide d'un masque de résine. Elle peut être réalisée avec des ions d'arsenic a une énergie de 130 keV et une dose de $5.10^{15}$ at/cm$^2$ pour les régions de type N+ et des ions Bore à une énergie de 40 keV et une dose de $3 \cdot 10^{15}$ at/cm$^2$ pour les régions de type P$^+$.

Le procédé de l'invention permet de réaliser dans les ci rcuits intégrés CMOS des liaisons à courte distance, c'est-à-dire des liaisons entre les sources et les drains de ces ci rcuits et/ou les grilles, sans effectuer au préalable le dépôt puis la gravure d'une couche d'isolant, ce qui permet d'augmenter de façon considérable la densité d'intégration de ces circuits.

En ce qui concerne les connexions à longue distance de ces circuits, celles-ci peuvent être réalisées de façon classique.

Le procédé de l'invention a été décrit dans le cas d'une connexion entre les drains d'un inverseur CMOS, mai s bien entendu il peut être utilisé pour d'autres types de connexion et en particulier pour connecter les grilles des transistors du circuit intégré aux sources ou aux drains de ces mêmes transistors.

## Revendications

1. Procédé pour interconnecter les zones actives d'un circuit intégré CMOS ou pour interconnecter les zones actives et les grilles de ce circuit, caractérisé en ce que, après avoir réalisé les éléments constitutifs du circuit intégré (32, 34, 38, 42, 44, 48, 50) à l'exception des connexions (52a) dudit circuit, on effectue les étapes successives suivantes :
   - dépôt directement sur l'ensemble du circuit intégré d'une couche (52) d'un matériau conducteur, dit premier matériau,
   - dépôt sur la couche (52) du premier matériau conducteur d'une couche (54) d'un matériau non réfléchissant, dit deuxième matériau, différent du premier matériau conducteur,
   - réalisation d'un masque de résine (56) sur la couche (54) du deuxième matériau représentant l'image du premier niveau d'interconnexions (52a) à réaliser,
   - élimination de la partie de la couche (54) du deuxième matériau dépourvue de masque,
   - élimination de la partie de la couche (52) du premier matériau conducteur dépourvue du restant (54a) de la couche (54) du deuxième matériau afin de réaliser le premier niveau d'interconnexions (52a), et
   - élimination du masque (56).

2. Procédé selon la revendication 1, caractérisé en ce que l'on effectue les étapes successives suivantes :
   - réalisation de bandes isolantes (57) sur les flancs des grilles (38, 48) du circuit intégré,
   - dépôt directement sur l'ensemble du circuit intégré de la couche (52) du premier matériau conducteur,
   - dépôt sur la couche (52) du premier matériau conducteur de la couche (54) du deuxième matériau non réfléchissant,
   - dépôt sur la couche (54) du deuxième matériau d'une première couche de résine (58) servant à effacer le relief de la couche (54) du deuxième matériau,

- réalisation d'une gravure de la première couche de résine (58) afin de ne laisser de la résine qu'aux emplacements des zones actives (34, 42) à interconnecter,

- réalisation dans une deuxième couche de résine (60) d'un masque représentant l'image du premier niveau d'interconnexions (52a) à réaliser,

- élimination de la partie de la couche (54) du deuxième matériau, dépourvue de résine (58, 60),

- élimination de la partie de la couche (52) du premier matériau conducteur non recouverte par le restant (54a) de la couche (54) du deuxième matériau, et

- élimination de la résine (58, 60).

3. Procédé selon la revendication 2, caractérisé en ce que, après la réalisation des bandes isolantes (57), on réalise dans les zones actives (32, 34, 42, 44) du circuit intégré une implantation ionique.

4. Procédé selon l'une quelconque des revendications 1 à 3, caractérisé en ce que la couche (54) du deuxième matériau est réalisée en silicium ou en oxyde de silicium.

5. Procédé selon l'une quelconque des revendications 1 à 4, caractérisé en ce que la couche (52) du premier matériau conducteur est réalisée en un alliage de titane et de tungstène.

6. Procédé selon l'une quelconque des revendications 1 à 5, caractérisé en ce que l'on grave la couche (52) du premier matériau conducteur au moyen d'un plasma.


**Patentansprüche**

1. Verfahren zum Verbinden der aktiven Zonen einer integrierten Schaltung des Typs CMOS oder zum Verbinden der aktiven Zonen und der Gates dieser Schaltung ,
dadurch **gekennzeichnet,**
daß nach Fertigstellung der Bestandteile der integrierten Schaltung (32, 34, 38, 42, 48, 50), mit Ausnahme der Verbindungen (52a) der genannten Schaltung, man nacheinander folgende Fertigungsschritte ausführt:
- Niederschlag einer Schicht (52) eines leitenden Materials, genannt erstes Material, direkt auf der ganzen integrierten Schaltung,
- Niederschlag einer Schicht (54) eines nichtreflektierenden Materials, genannt zweites Material, unterschiedlich vom ersten leitenden Material, auf der Schicht (52) des ersten leitenden Materials,

- Gestalten einer Harzmaske (56) auf der Schicht (54) des zweiten Materials, die eine Abbildung der herzustellenden ersten Verbindungsebene (52a) darstellt,

- Beseitigung des Teils der Schicht (54) des zweiten Materials, das von der Maske nicht abgedeckt ist.

- Beseitigung des Teils der Schicht (52) des ersten, leitenden Materials, das vom Rest (54a) der Schicht (54) des zweiten Materials nicht abgedeckt ist, um die erste Verbindungsebene (52a) zu verwirklichen, und

- Beseitigung der Maske (56) .

2. Verfahren nach Anspruch 1, dadurch gekennzeichnet, daß man nacheinander folgende Fertigungsschritte ausführt:
- Gestaltung der isolierenden Rändern (57) auf den Flanken der Gates (38, 48) der integrierten Schaltung ,
- Niederschlag der Schicht (52) des ersten, leitenden Materials direkt auf der ganzen integrierten Schaltung,
- Niederschlag der Schicht (54) des zweiten, nichtreflektierenden Materials auf der Schicht (52) des ersten, leitenden Materials ,
- Niederschlag auf der Schicht (54) des zweiten Materials einer ersten Harzschicht (58), die den Zweck hat, die Vertiefungen des Reliefs der Schicht (54) des zweiten Materials zu füllen,
- Ätzung der ersten Harzschicht (58), so daß nur an den Stellen der zu verbindenden aktiven Zonen (34, 42) Harz zurückbleibt,
- Gestaltung einer Abbildung der herzustellenden ersten Verbindungsebene (52a) mit einer zweiten Harzschicht (60)
- Beseitigung des Teils der Schicht (54) aus dem zweiten Material, der nicht mit Harz (58, 60) bedeckt ist,
- Beseitigung des Teils der Schicht (52) des ersten, leitenden Materials, der nicht bedeckt ist vom Rest (54a) der Schicht (54) des zweiten Materials, und
- Beseitigung des Harzes (58, 60).

3. Verfahren nach Anspruch 2, dadurch gekennzeichnet, daß man nach Gestaltung der isolierenden Ränder (57) in den aktiven Zonen (32, 34, 42, 44) des Schaltkreises eine Ionenimplantation durchführt.

4. Verfahren nach irgendeinem der Ansprüche 1 bis 3, dadurch gekennzeichnet, daß die Schicht (54) des zweiten Materials in Silizium oder Siliziumoxyd ausgeführt ist.

5. Verfahren nach irgendeinem der Ansprüche 1 bis 4, dadurch gekennzeichnet, daß die Schicht (52) des ersten, leitenden Materials in einer Titan- oder Tungstenlegierung ausgeführt ist.

6. Verfahren nach irgendeinem der Ansprüche 1 bis 5, dadurch gekennzeichnet, daß man die Schicht (52) des ersten, leitenden Materials mittels Plasma ätzt.

**Claims**

1. Method for interconnecting the active zones of a CMOS integrated circuit or for interconnecting the active zones and gates of said circuit, characterized in that, after producing the constituent elements of the integrated circuit (32, 34, 38, 42, 44, 48, 50), with the exception of the connections (52a) of said circuit, the following stages are performed:
   - direct deposition on the complete integrated circuit of a coating (52) of a conductive material, called the first material,
   - deposition on the first conductive material coating (52) of a non-reflecting material coating (54) of the second material and which differs from the first conductive material, production of a resin mask (46) on the coating (54) of the second material representing the image of the first interconnection level (52a) to be produced,
   - elimination of that part of the coating (54) of the second material which is free from the mask,
   - elimination of that part of the coating (52) of the first conductive material free from the remainder (54a) of the second material coating (54) in order to produce the fist interconnection level (52a) and
   - elimination of the mask (56).

2. Method according to claim 1, characterized in that the following successive stages are performed:
   - production of insulating strips (57) on the edges of the integrated circuit gates (38, 48),
   - direct deposition on the complete integrated circuit of the first conductive material coating (52),
   - deposition on the first conductive material coating (52) of the coating (54) of the second non-reflecting material,
   - deposition on the second material coating (54) of a first resin coating (58) for cancelling out the relief of the second material coating (54),
   - etching the first resin coating (58) so as to only leave resin at the locations of the active zones (34, 42) to be interconnected,
   - producing in a second resin coating (60) a mask representing the image of the first interconnection level (52a) to be produced,
   - elimination of that part of the second material coating (54) which is free from resin (58, 60),
   - elimination of that part of the first conductive material coating (52) not covered by the remainder (54a) of the second material coating (54) and
   - elimination of the resin (58, 60).

3. Process according to claim 2, characterized in that, after producing the insulating strips (57), ion implantation takes place in the active zones (32, 34, 42, 44) of the integrated circuit.

4. Process according to any one of the claims 1 to 3, characterized in that the second material coating (54) is made from silicon or silicon dioxide.

5. Process according to any one of the claims 1 to 4, characterized in that the first conductive material coating (52) is made from an alloy of titanium and tungsten.

6. Process according to any one of the claims 1 to 5, characterized in that the first conductive material coating (52) is etched by means of a plasma.

FIG.1

FIG.2

FIG.3

FIG.4

FIG.5

## FIG.6

58
54
52
28
N+
32 38 57 34
N+
50
P+
42 48
P+
44
30

## FIG.7

57
58
60 58
54
52
28 32 38
34
N+
P
N+
50
P+
N 42
48
44
30

## FIG.8

60
58
54a
52a
54
52
28 32 38
34
N+
P
N+
50
P+
N 42
48
44
30

## FIG.9

52a
54a
28 32 38
34
P
N+
50
P+
N 42
48
P+
30